# EUROPÄISCHE PATENTSCHRIFT

(11) **EP 0 962 122 B1**
(45) Veröffentlichungstag und Bekanntmachung des Hinweises auf die Patenterteilung: **13.06.2001**
(21) Anmeldenummer: 98913521.5
(22) Anmeldetag: 25.02.1998
(51) Int. Cl.: H05K 5/00, G05D 23/19

(54) **REGLER, INSBESONDERE TEMPERATURREGLER WIE RAUMTEMPERATURREGLER**
CONTROL DEVICE, ESPECIALLY A TEMPERATURE CONTROL DEVICE SUCH AS A ROOM TEMPERATURE CONTROL DEVICE
REGULATEUR, NOTAMMENT THERMOSTAT TEL QU'UN THERMOSTAT D'AMBIANCE

(30) Priorität: 28.02.1997 DE 19708210
(43) Veröffentlichungstag der Anmeldung: 08.12.1999
(73) Patentinhaber: INTER CONTROL Hermann Köhler Elektrik GmbH u. Co. KG, D-90411 Nürnberg (DE)
(72) Erfinder: WOLF, Roland, D-91217 Hersbruck (DE); EGGEBRECHT, Frank, D-90518 Altdorf (DE); KÖHLER, Hermann, G., D-90480 Nürnberg (DE); FRENZEL, Bernhard, D-90559 Burgthann (DE); NEUBAUER, Michael, D-90411 Nürnberg (DE)
(74) Vertreter: Hafner, Dieter, Dr. Dipl.-Phys.
(86) Internationale Anmeldenummer: DE9800549
(87) Internationale Veröffentlichungsnummer: WO9838843

(56) Entgegenhaltungen:
- DE-A- 4 300 342
- DE-A- 19 546 164
- DE-C- 4 142 138
- GB-A- 2 094 503
- US-A- 5 434 362

## Beschreibung

Die Erfindung betrifft einen Regler, insbesondere einen Temperaturregler mit den Merkmalen des Patentanspruchs 1.

Üblicherweise bestehen Regler aus einem Reglergehäuse, in welchen ein Sensor, ein Sollwertgeber, ein elektronisches und/oder elektromechanisches Schaltglied in Form eines Relais mit Schaltkontakten, eine Stromversorgungseinheit und eine Reglerelektronik angeordnet sind. Solche Regler werden in Form von Raumthermostaten als Raumtemperaturregler für Klimageräte und Speicherheizgeräte eingesetzt. Weitere Anwendungsmöglichkeiten ergeben sich in Kühlschränken, in Wanddirektheizgeräten, Kochherden, Automobilen, Warmwasserheizungen und dgl..

Herkömmliche Regler der in Frage stehenden Art sind so aufgebaut, daß sie eine in einem Gehäuse befindliche Montageplatine aufweisen, auf der die wesentlichen Baugruppen wie Stromversorgung, Signalverarbeitung, Einstelleinheit und Schaltglied angeordnet sind. Ein Temperaturfühler, der zu einem solchen Gerät funktionsmäßig gehört, kann entweder in das Gehäuse integriert oder aber auch ausgelagert und mit Kabeln mit dem Raumtemperaturregler verbunden sein. Ein solcher Regler ist aus Dokument GB-A-2 094 503 bekannt Herkömmliche Regler der in Frage stehenden Art sind insofern nachteilig, als die Anzahl der mechanischen Bauteile relativ hoch ist und beim Gesamtpreis eines solchen Gerätes insbesondere der Montagekostenanteil wesentlich ins Gewicht fällt.

Der Erfindung liegt die Aufgabe zugrunde, einen derartigen Regler von seinem Aufbau her zu vereinfachen und zu integrieren und so auszubilden, daß wesentliche tragende Teile und Verdrahtungselemente entfallen können.

Diese Aufgabe wird durch die Merkmale des Patentanspruchs 1 gelöst. Vorteilhafte Weiterbildungen ergeben sich aus den Ansprüchen 2-11.

Als Kern der Erfindung wird es angesehen, den Regler in MID-Technologie aufzubauen, wobei die vom Regler umfaßten elektronischen und/oder elektromechanischen Bauelemente von Wandungen, von Gehäuseinnenabschnitten und/oder damit verbundenen Halteelementen gehalten bzw. getragen werden. Dabei weist der Regler nach außen rührende Anschlußkontakte auf. Das Reglergehäuse wird also im kostengünstigen Spritzgußverfahren hergestellt und ist so gestaltet, daß die elektronischen und/oder elektromechanischen Bauelemente anschließend in die Gehäuseinnenabschnitte einfach eingesetzt werden können. Die vom Regler nach außen führenden Anschlußkontakte können entweder sofort mit eingespritzt werden oder werden nachträglich in die Gehäusewandung eingesteckt. Der in MID-Technologie aufgebaute Regler weist ferner Leiterbahnen auf dem Gehäuseboden und/oder den Gehäusewandungen und/oder Gehäuseinnenabschnitten auf, die die elektronischen und/oder elektromechanischen Bauelemente miteinander verbinden. Diese Leiterbahnen und Kontakte werden beispielsweise über Metallisierungs- und Fotoprozesse erzeugt.

Durch die MID-Technologie wird ein Regler geschaffen, der auf einfache Weise zu montieren ist, mit relativ wenigen Einzelteilen auskommt sowie in gekapselter Bauweise und sehr kleinvolumig hergestellt werden kann. Das Gehäuse dient nicht nur als Leiterbahnträger, sondern auch als Träger und zur Führung von mechanischen sich bewegenden Bauteilen.

Die Verwendung von der MID-Technologie zur Herstellung von Gehäusen für Steuergeräte, in denen das Gehäuse als Leiterbahnträger dient, ist in der Offenlegungsschrift DE-A-4 300 342 offenbart.

Vorteilhafterweise kann das Gehäuse aus einem Oberteil und einem Unterteil zusammengesetzt sein, so daß eine einfache Montage der Bauelemente gewährleistet ist.

Dabei sind Oberteil und Unterteil des Gehäuses vorteilhafterweise derart gestaltet, daß sie miteinander oder auch die Gehäuseinnenabschnitte hermetisch abschließen. Ein derartiger luft- und wasserdichter Verschluß gewährleistet einen relativ störungsfreien Betrieb und damit eine exakte Temperaturregelung.

Ganz besonders vorteilhaft ist es, wenn die Gehäusewandungen einstückig an das Oberteil bzw. Unterteil des Gehäuses angeformt sind. Zum einen können damit die Gehäusewandungen in einem Fertigungsschritt mit dem Oberteil oder Unterteil des Gehäuses hergestellt werden, was durch den Spritzgußprozeß relativ einfach zu realisieren ist. Zum anderen dichten die Gehäusewandungen dort, wo sie an das jeweilige Oberteil bzw. Unterteil angeformt sind, optimal ab.

In einem ersten Gehäuseinnenabschnitt ist ein Kontaktpaar angeordnet, das unmittelbar von den Gehäusewandungen gehalten wird und das mit Anschlußkontakten die äußere Gehäusewandung durchsetzt. Ein Kontakt soll dabei ein Bewegungskontakt sein, der andere ist als Festkontakt ausgebildet. Der Bewegungskontakt wird durch eine Öffnung in einer inneren Gehäusewandung hindurch betätigt.

In einem zweiten Gehäuseinnenabschnitt, der benachbart zum ersten Gehäuseinnenabschnitt liegt, ist eine Aktivierungsvorrichtung vorgesehen, die mit einem die besagte innere Gehäusewandung durchsetzenden Element den Bewegungskontakt beaufschlagt.

Zweckmäßigerweise umfaßt die Aktivierungsvorrichtung eine mit einem Ankerblech versehene Relaisspule, die unmittelbar durch das Gehäuse gehalten ist.

In einem dritten Gehäuseinnenabschnitt sind elektronische Bauteile angeordnet, die untereinander sowie mit den weiteren elektromechanischen Bauteilen durch die Leiterbahnen verbunden sind.

In einem vierten Gehäuseinnenabschnitt kann eine Einstellwelle angeordnet sein, wobei im Bereich des Gehäusebodens, d.h. auf der Innenseite des Gehäusebodens eine Widerstandsbahn eines Potentiometers oder eine Leiterbahn mit sicher peripher ändernden optischen Reflexionseigenschaften angeordnet ist. Die Widerstandsbahn wird von einem Kontakt abgetastet, der mit einer Einstellwelle in Verbindung steht. Die Einstellwelle der Einstelleinheit kann drehbar in das Unterteil des Gehäuses oder einem daran angespritzten Führungsteil sowie dem Oberteil des Gehäuses oder einer daran eingespritzten Führungshülse geführt sein.

Vorteilhafterweise ist der vierte Gehäuseinnenabschnitt kreisförmig ausgebildet, so daß die Einstellwelle leicht montiert werden kann und eine gute Führung der Einstellwelle gewährleistet ist. Die gesonderte Kapselung der Einstelleinheit ist störunanfällig. Die nach außen führenden Anschlußkontakte können unmittelbar von äußeren Gehäuseteilen getragen werden. Werden die

Anschlußkontakte unmittelbar in die äußere Gehäusewandung eingespritzt, so kann die Verbindung von Anschlußkontakten und Gehäusewandung ausreichend dicht ausgebildet werden. Außerdem ist durch diese Art der Fertigung kein zusätzlicher Fertigungsschritt für die Montage der Anschlußkontakte erforderlich.

Der Sensor kann getrennt von der Reglereinheit angeordnet sein und unterschiedliche physikalische Größen erfassen. Bei einem Defekt kann dieser somit einfach ausgewechselt werden.

Die Erfindung ist anhand eines vorteilhaften Ausführungsbeispiels in den Zeichnungsfiguren näher erläutert. Diese zeigen:
- Fig. 1: eine Draufsicht auf das geöffnete Gehäuse des Reglers mit den unmittelbar auf der Innenseite des Gehäusebodens aufgebrachten Baugruppen;
- Fig. 2: eine perspektivische Ansicht des Reglergehäuses,
- Fig. 3: eine perspektivische Ansicht des Unterteils des Reglergehäuses sowie
- Fig. 4: eine perspektivische Ansicht des Oberteils des Reglergehäuses.

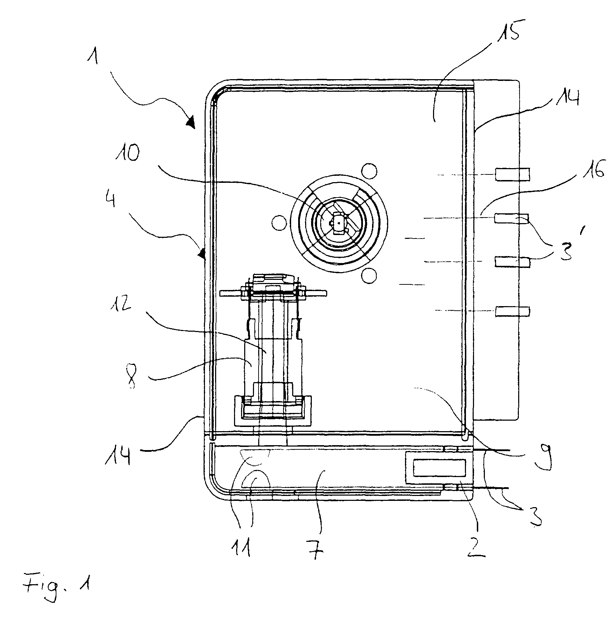

Der in MID-Technologie aufgebaute Regler 1 ist in Fig. 1 in der Draufsicht beispielhaft dargestellt. Der Regler 1 weist ein Gehäuse 4 auf, das aus einem Gehäuseboden 15, äußeren Gehäusewandungen 14 und einer Mehrzahl von Gehäuseinnenabschnitten 7, 8, 9, 10 besteht. Der Regler 1 beinhaltet elektronische und/oder elektromechanische Bauelemente, welche von den Wandungen des Gehäuses 4, von den Gehäuseinnenabschnitten 7, 8, 9, 10 und/oder damit verbundenen Halteelementen 2 gehalten bzw. getragen werden. Ferner weist der Regler 1 nach außen führende Anschlußkontakte 3, 3' auf, welche entweder zusammen mit dem Spritzgußvorgang eingespritzt oder nachträglich eingesteckt bzw. auf Gehäuseteile aufgedrückt werden. Außerdem sind die elektronischen und/oder elektromechanischen Bauteile untereinander durch unmittelbar auf den Gehäuseboden 15 aufgebrachten Leiterbahnen 16 verbunden. Diese Leiterbahnen 16 sind in Fig. 1 nur schematisch angedeutet und können auch an den Gehäusewandungen und/oder Gehäuseinnenabschnitten 7, 8, 9, 10 aufgebracht sein.

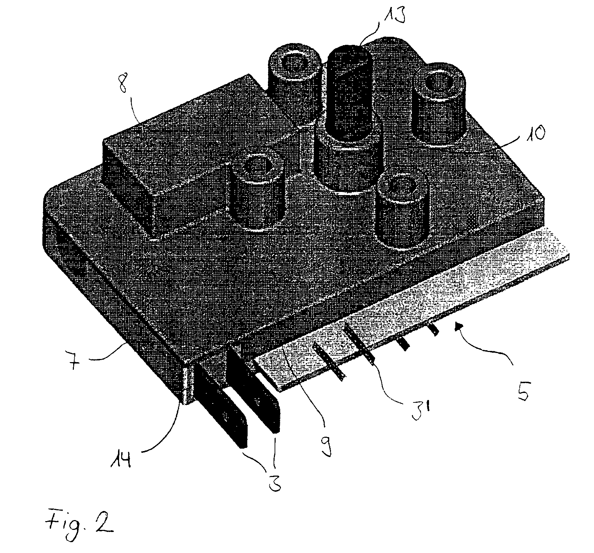

Aus der perspektivischen Darstellung des Reglers 1 in Fig. 2 ist zu erkennen, daß das Gehäuse 4 aus einem Oberteil 5 und einem Unterteil 6 zusammengesetzt sind. Dabei sind das Oberteil 5 und das Unterteil 6 des Gehäuses 4 so gestaltet, daß sie die Gehäuseinnenabschnitte 7, 8, 9, 10 hermetisch abschließen.

Die um den vierten Gehäuseinnenabschnitt 10 angeordneten kreisförmigen Ausformungen dienen der Aufnahme von Befestigungsmitteln, beispielsweise Schrauben.

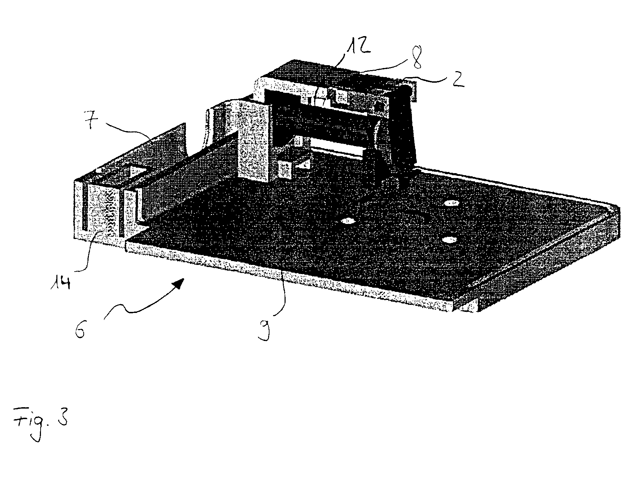

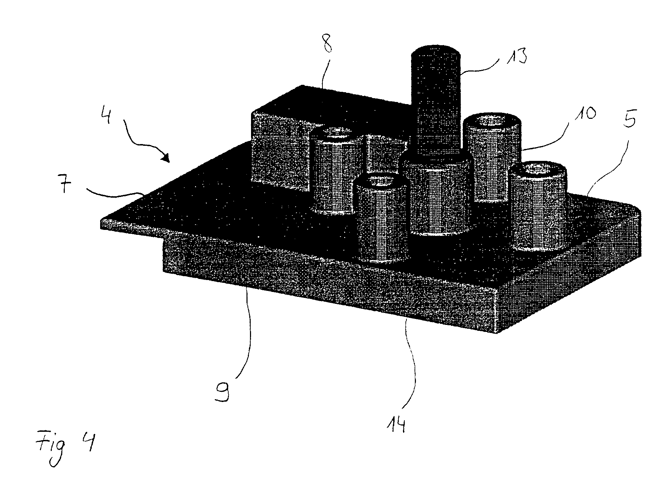

Wie aus Fig. 3 und 4 ersichtlich, sind die Gehäusewandungen einstückig an das Oberteil 5 bzw. Oberteil 6 des Gehäuses 4 angeformt. Die Gehäusewandungen dienen der Halterung bzw. der Aufnahme der elektronischen und/oder elektromechanischen Bauelemente und sind dabei so konstruiert, daß sie verschiedene Gehäuseinnenabschnitte 7, 8, 9, 10 darstellen. Im ersten Gehäuseinnenabschnitt 7 ist ein Kontaktpaar 11 angeordnet, das unmittelbar von den Gehäusewandungen und einem Halteelement 2, die unmittelbar an das Gehäuse 4 angespritzt sind, gehalten wird. Das Kontaktpaar 11 besteht aus einem Fest- und einem Bewegungskontakt und ist mit Anschlußkontakten 3 verbunden, die die äußere Gehäusewandung 14 durchsetzen.

In einem zweiten Gehäuseinnenabschnitt 8 befindet sich eine Aktivierungsvorrichtung. Die Aktivierungsvorrichtung umfaßt im wesentlichen eine mit einem Ankerblech versehene Relaisspule 12, die unmittelbar durch den dafür geformten zweiten Gehäuseinnenabschnitt 8 gehalten ist.

In einem dritten Gehäuseinnenabschnitt 9 ist eine Mehrzahl von elektronischen Bauteilen angeordnet, die untereinander durch unmittelbar auf dem Gehäuseboden 15 aufgedruckten Leiterbahnen 16 verbunden sind. Die elektronischen Bauteile werden ebenfalls unmittelbar vom Gehäuseboden 15 getragen, so daß der Gehäuseboden 15 als Schaltungs- und Bauteileträger dient.

In einem vierten Gehäuseinnenabschnitt 10 ist eine Einstellwelle 13 angeordnet, die mit einer Einstelleinheit verbunden ist. Die Einstelleinheit umfaßt eine im Bereich des Gehäusebodens 15 nicht näher dargestellte befestigte Widerstandsbahn. Die Einstellwelle 13 der Einstelleinheit ist drehbar im Unterteil 6 des Gehäuses 4 sowie dem Oberteil 5 des Gehäuses 4 geführt. Dieser vierte Gehäuseinnenabschnitt 10 ist kreisförmig ausgebildet und umschließt die Einstelleinheit hermetisch, so daß diese gegen Staub und äußere Einflüsse geschützt ist.

Aus der äußeren Gehäusewandung 14 steht eine Mehrzahl von weiteren Anschlußkontakten 3' heraus An diese Anschlußkontakte 3' ist beispielsweise ein externer Temperatursensor angeschlossen. Eine besondere Ausführungsart dieses Sensors ist im Anspruch 10 angegeben.

## Patentansprüche

1. Regler, insbesondere Temperaturregler, mit einem Sensor, einem Sollwertgeber, einem elektromechanischen Schaltglied, einer Stromversorgungseinheit, einer Reglerelektronik und einem diese Bauteile umfassenden Gehäuse, wobei
- der Regler (1) in MID-Technologie aufgebaut ist und die vom Regler (1) umfaßten elektronischen und/oder elektromechanischen Bauelemente von Wandungen, von Gehäuseinnenabschnitten (7, 8, 9, 10) und/oder damit verbundenen Halteelementen (2) gehalten bzw. getragen werden,
- der Regler (1) nach außen rührende Anschlußkontakte (3, 3') aufweist und
- die elektronischen und/oder elektromechanischen Bauteile untereinander durch unmittelbar auf dem Gehäuseboden (15) und/oder Wandungen und/oder Gehäuseinnenabschnitten (7, 8, 9 10) aufgebrachten Leiterbahnen (16) verbunden sind.
- die Gehäuswandungen einstückig an einem Abschnitt des Gehäuses (4) angeformt sind,
- in einem ersten Gehäuseinnenabschnitt (7) ein Kontaktpaar (11) angeordnet ist, das unmittelbar von den Gehäusewandungen und/oder Halteelementen (2) gehalten wird und mit Anschlußkontakten (3) eine äußere Gehäusewandung (14) durchsetzt sowie
- in einem zweiten Gehäuseinnenabschnitt (8) eine Aktivierungsvorrichtung angeordnet ist, die eine mit einem Ankerblech versehene Relaisspule (12) umfaßt, die unmittelbar durch das Gehäuse (4) gehalten ist und in MID-Technik mit den elektronischen Bauelementen verbunden ist, die in einem dritten Gehäuseabschnitt (9) angeordnet sind.

2. Regler nach Anspruch 1,
**dadurch gekennzeichnet, daß**
das Gehäuse (4) aus einem Oberteil (5) und einem Unterteil (6) zusammengesetzt ist.

3. Regler nach einem der Ansprüche 1 oder 2,
**dadurch gekennzeichnet, daß**
das Oberteil (5) und das Unterteil (6) den Innenbereich des Gehäuses (4) oder die Gehäuseinnenabschnitte (7, 8, 9, 10) hermetisch abschließen.

4. Regler nach einem der vorhergehenden Ansprüche,
**dadurch gekennzeichnet, daß**
in einem vierten Gehäuseinnenabschnitt (10) eine Einstellwelle (13) angeordnet ist, die mit einer Einstelleinheit verbunden ist.

5. Regler nach Anspruch 4,
**dadurch gekennzeichnet, daß**
die Einstellwelle (13) der Einstelleinheit drehbar in das Unterteil (6) des Gehäuses (4) oder einem daran angespritzten Führungsteil sowie dem Oberteil (5) des Gehäuses (4) oder einer daran angespritzten Führungshülse geführt ist.

6. Regler nach den Ansprüchen 4 oder 5,
**dadurch gekennzeichnet, daß**
der vierte Gehäuseinnenabschnitt (10) kreisförmig ausgebildet ist.

7. Regler nach einem der vorhergehenden Ansprüche,
**dadurch gekennzeichnet, daß**
die nach außen führenden Anschlußkontakte (3, 3') unmittelbar von äußeren Gehäuseteilen getragen werden.

8. Regler nach einem der vorhergehenden Ansprüche,
**dadurch gekennzeichnet, daß**
der Sensor getrennt von der Reglereinheit angeordnet ist und physikalische Größen erfassen kann.

9. Regler nach Anspruch 8,
**dadurch gekennzeichnet, daß**
der Sensor ein Temperatursenor ist.

10. Regler nach Anspruch 9,
**dadurch gekennzeichnet, daß**
der Sensor eine temperaturabhängige Paste ist, die auf dem Gehäuse (4) angebracht ist.

11. Regler nach einem der vorhergehenden Ansprüche,
**dadurch gekennzeichnet, daß**
der Regler (1) einen Prozessor enthält, der zusätzliche logische Funktionen und Verknüpfungen bearbeiten kann.

## Revendications

1. Régulateur, notamment régulateur thermique comprenant un capteur, un indicateur de valeurs de consigne, un organe de commutation électromécanique, une unité d'alimentation en courant, une électronique de régulation et un boîtier renfermant ces composants, sachant que
- le régulateur (1) est structurellement agencé selon la technologie MID et les éléments structurels électroniques et/ou électromécaniques, englobés par ledit régulateur (1), sont respectivement retenus ou portés par des parois, par des zones intérieures (7, 8, 9, 10) du boîtier et/ou par des éléments de retenue (2) reliés à ces dernières,
- le régulateur (1) présente des contacts de raccordement (3, 3') gagnant l'extérieur,
- les composants électroniques et/ou électromécaniques sont reliés les uns aux autres par des pistes conductrices (16) directement appliquées sur le fond (15) du boîtier et/ou sur des parois et/ou sur des zones intérieures (7, 8, 9, 10) dudit boîtier,
- les parois du boîtier sont moulées d'un seul tenant avec une zone dudit boîtier (4),
- une paire de contacts (11), disposée dans une première zone intérieure (7) du boîtier, est directement retenue par les parois dudit boîtier et/ou par des éléments de retenue (2), et traverse une paroi extérieure (14) dudit boîtier par des contacts de raccordement (3), et
- un dispositif d'activation, logé dans une deuxième zone intérieure (8) du boîtier, comprend une bobine de relais. (12) qui est munie d'une tôle d'induit, est directement retenue par le boîtier (4) et est reliée, selon la technique MID, aux composants électroniques logés dans une troisième zone (9) dudit boîtier.

2. Régulateur selon la revendication 1,
caractérisé par le fait que
le boîtier (4) est composé d'une partie supérieure (5) et d'une partie inférieure (6).

3. Régulateur selon l'une des revendications 1 ou 2,
caractérisé par le fait que
la partie supérieure (5) et la partie inférieure (6) obturent hermétiquement la région interne du boîtier (4) ou les zones intérieures (7, 8, 9, 10) dudit boîtier.

4. Régulateur selon l'une des revendications précédentes,
caractérisé par le fait
qu'un arbre de réglage (13), relié à une unité de réglage, est logé dans une quatrième zone intérieure (10) du boîtier.

5. Régulateur selon la revendication 4,
caractérisé par le fait que
l'arbre de réglage (13) de l'unité de réglage est guidé à rotation dans la partie inférieure (6) du boîtier (4), ou dans une partie de guidage venue solidairement de moulage par injection avec cette dernière, ainsi que dans la partie supérieure (5) dudit boîtier (4), ou dans une douille de guidage venue solidairement de moulage par injection avec cette dernière.

6. Régulateur selon les revendications 4 ou 5,
caractérisé par le fait que
la quatrième zone intérieure (10) du boîtier est de réalisation circulaire.

7. Régulateur selon l'une des revendications précédentes,
caractérisé par le fait que
les contacts de raccordement (3, 3'), gagnant l'extérieur, sont directement portés par des parties extérieures du boîtier.

8. Régulateur selon l'une des revendications précédentes,
caractérisé par le fait que
le capteur est agencé séparément de l'unité de régulation, et peut détecter des grandeurs physiques.

9. Régulateur selon la revendication 8,
caractérisé par le fait que le capteur est une sonde thermométrique.

10. Régulateur selon la revendication 9,
caractérisé par le fait que
le capteur est une pâte thermovariable appliquée sur le boîtier (4).

11. Régulateur selon l'une des revendications précédentes,
caractérisé par le fait que ledit régulateur (1) renferme un processeur pouvant traiter des fonctions et combinaisons logiques additionnelles.

## Claims

1. Control device, in particular a temperature control device, with a sensor, a setpoint unit, an electronic switch, a current supply, control electronics, and a housing enclosing these components,
**characterized by the fact that**
- the control device (1) is constructed in MID technology and the electronic and/or electromechanical components included in the control device (1) are supported or carried by walls, by housing inner sections (7, 8, 9, 10) and/or support elements (2) connected thereto,
- the control device (1) displays outward-leading connection contacts (3, 3'),
- the electronic and/or electromechanical components are connected to one another through conductor paths (16) applied directly to the housing bottom (15) and/or the walls and/or the housing inner sections (7, 8, 9, 10),
- the housing walls are formed onto one section of the housing (4) as one piece,
- arranged in a first housing inner section (7) is a pair of contacts (11) that are supported directly by the housing walls and/or support elements (2) and that pass through the outer housing wall (14) with connection contacts (3), and
- arranged in a second housing inner section (8) is an activation device that comprises a relay coil (12) provided with a core plate, which relay coil is supported directly by the housing (4) and is connected to the electronic components in MID technology, which components are arranged in a third housing section (9).

2. Control device according to claim 1,
**characterized by the fact that**
the housing (4) is composed of an upper section (5) and a lower section (6).

3. Control device according to one of the claims 1 or 2,
**characterized by the fact that**
the upper part (5) and the lower part (6) hermetically enclose the inner region of the housing (4) or the housing inner sections (7, 8, 9, 10).

4. Control device according to one of the preceding claims,
**characterized by the fact that**
arranged in a fourth housing inner section (10) is an adjustment shaft (13), which is connected to an adjustment unit.

5. Control device according to claim 4,
**characterized by the fact that**
the adjustment shaft (13) of the adjustment unit is guided rotatably in the lower part (6) of the housing (4) or in a guide piece injection-molded onto the latter, as well as the upper part (5) of the housing (4) or in a guide bushing injection-molded onto the latter.

6. Control device according to claim 4 or 5,
**characterized by the fact that**
the fourth housing inner section (10) is designed so as to be circular in shape.

7. Control device according to one of the preceding claims,
**characterized by the fact that**
the outward-leading connection contacts (3, 3') are borne directly by the outer housing parts.

8. Control device according to one of the preceding claims,
**characterized by the fact that**
the sensor is arranged so as to be separate from the control device and can ascertain physical magnitudes.

9. Control device according to claim 8,
**characterized by the fact that**
the sensor is a temperature sensor.

10. Control device according to claim 9,
**characterized by the fact that**
the sensor is a temperature-sensitive mass that is attached to the housing (4).

11. Control device according to one of the preceding claims,
**characterized by the fact that**
the control device (1) contains a processor that can process additional logical functions and links.
